(19) Europäisches Patentamt / European Patent Office / Office européen des brevets

(11) **EP 4 475 414 A1**

(12) **EUROPEAN PATENT APPLICATION**

(43) Date of publication:
**11.12.2024 Bulletin 2024/50**

(21) Application number: 23177505.7

(22) Date of filing: **06.06.2023**

(51) International Patent Classification (IPC):
*H02M 1/32* (2007.01)        *H02M 7/5387* (2007.01)
*G01R 31/42* (2006.01)        *G01R 31/52* (2020.01)

(52) Cooperative Patent Classification (CPC):
**H02M 1/32; G01R 31/42; G01R 31/52;
H02M 1/0009; H02M 1/348; H02M 7/487;
H02M 7/5387**

(84) Designated Contracting States:
**AL AT BE BG CH CY CZ DE DK EE ES FI FR GB
GR HR HU IE IS IT LI LT LU LV MC ME MK MT NL
NO PL PT RO RS SE SI SK SM TR**
Designated Extension States:
**BA**
Designated Validation States:
**KH MA MD TN**

(71) Applicant: **ABB SCHWEIZ AG
5400 Baden (CH)**

(72) Inventors:
• **VETTERLI, Manuel
  4053 Basel (CH)**
• **REIGOSA, Paula Diaz
  8005 Zürich (CH)**
• **ABRACH, Stefan
  8005 Zürich (CH)**
• **LUESCHER, Matthias
  5728 Gontenschwil (CH)**

(74) Representative: **Sykora & König Patentanwälte
PartG mbB
Maximilianstraße 2
80539 München (DE)**

(54) **METHOD AND COMPUTER PROGRAM FOR DETECTING A SHORT-CIRCUIT IN A POWER CONVERTER, CONTROLLER FOR CONTROLLING A POWER CONVERTER, AND COMPUTER-READABLE MEDIUM**

(57)     A method for detecting a short-circuit (18) in a power converter (20) is provided. The power converter (20) comprises a first DC terminal (22), a second DC terminal (24), an AC terminal (26), a first semiconductor switch (S 1) electrically coupled to the first DC terminal (22) and the AC terminal (26), a second semiconductor switch (S2) electrically coupled to the second DC terminal (24) and the AC terminal (26), and an inductance. The method comprises: sending a turn-on signal (ON) to the first semiconductor switch (S 1) for turning on the first semiconductor switch (S 1) and a turn-off signal (OFF) to the second semiconductor switch (S2) for turning off the second semiconductor switch (S2); receiving a voltage signal which is representative for a switch voltage ($v_{S1}$, $v_{S2}$) measured over the first semiconductor switch (S 1) and the second semiconductor switch (S2); determining an inductance voltage ($V_L$) over the inductance depending on the measured switch voltage ($v_{S1}$, $v_{S2}$) and a DC voltage ($V_{DC}$) between the first and second DC terminals (24); determining a current (isc) flowing through the semiconductor switches (S 1, S2) depending on the determined inductance voltage ($V_L$); and determining that the short-circuit (18) is present depending on a predetermined current threshold.

Fig. 1

EP 4 475 414 A1

**Description**

FIELD OF THE INVENTION

The invention relates to the field of power converters and more particularly to the field of Power Electronic Converters (PECs), e.g. for motor drives or wind converters. In particular, the invention relates to a method and a computer program for detecting a short-circuit in a power converter, to a controller for controlling the power converter, and to a computer-readable medium on which the computer program is stored.

BACKGROUND OF THE INVENTION

One of the most well-known multilevel conversion architectures, especially in medium voltage drive applications, is the Neutral Point Clamped (NPC) converter topology. The main advantages of this topology include modularity and scalability to different voltage and power levels, high efficiency, and low harmonic distortions in the output voltages. For reasons of simplicity, a phase of a two-level converter using IGBTs connected to a DC link capacitor is used for this description. However, the following invention is generic in nature and can be extended to multi-level topologies, for example to a 3L-ANPC topology.

The reliability of such converters is one of the challenges that need to be addressed, since medium-voltage multilevel converters have typically many semiconductor switches arranged in series and/or in parallel to increase either the voltage or, respectively, the current levels. By increasing the rated power of the converter, the number of power semiconductors may also be increased and thus, the reliability of the whole system may decrease. Any electrical fault, such as a short-circuit fault, may cause the malfunction of the whole medium-voltage system drive or even a catastrophic failure when the system does not include effective detection/protection functions. Therefore, the converter should be designed to have an effective fault-detecting method. Therefore, some modern PECs implement a protection concept to prevent hazards to persons and to minimize, respectively limit equipment damage in case of a fault.

One important fault case is the short-circuit, where current starts to build up uncontrolled, e.g. because of a breakdown of an insulation (e.g. "flashover") or breakdown of a component of the converter (e.g. IGBT loss of blocking capability). For example, considering a case in which an AC output of the exemplary phase of the two-level converter is shorted to one of the corresponding DC-supplies of the converter, e.g. because of a fault of a semiconductor switch coupling the AC output to the corresponding DC-supply. When the output is coupled to the other DC-supply, e.g. by turning off the faulted semiconductor switch and by turning on the other semiconductor switch of that phase, a short-circuit current starts to build up. It may be vital to detect this short-circuit condition quickly and reliably to limit the effects of the short-circuit and to not cause any cascading failures to neighboring power components or circuits of the same power converter or another electronic component.

Different short-circuit detection methods are already known. For example: a direct measurement of the current with one or more shunts, current transducers, or Rogowski coils, monitoring a voltage drop across one or more parasitic inductances (e.g. emitter inductance in IGBT modules), a desaturation detection in IGBTs, etc. However, in most fault-detecting methods, additional components have to be added to the circuitry of the corresponding converter, which adds complexity. This may contribute to high cost and/or may reduce a reliability of the converter.

Other approaches are based on end-of-life estimation models of electronic components of the power converter (i.e., capacitors, power semiconductors...) to be able to predict failures before they occur. This approach may help to identify weak points of the power converter and may enable to schedule maintenance periods. However, the converter still needs to include a method to detect and react on faults.

Further, many methods have been published in the literature as fault-tolerant solutions for power electronic systems. For example, a detection and protection of the semiconductor devices via the corresponding gate drive, diagnostic solutions for medium-voltage drive systems with lower number of power semiconductor devices, and a larger number of fault-tolerant control strategies for medium voltage drives. However, the problem is that the available solutions are difficult to be implemented for medium-voltage drive application with a larger number of components. The common problems are either because too many sensors are used and the data is difficult to handle, or the measured data is too heavy to be transferred through the communication protocols and to be finally processed.

An example of this problem is the detection of a power semiconductor short-circuit fault, which is typically based on the well-known desaturation protection circuit integrated in the gate driver. An on-state voltage of the semiconductor device is measured and compared to a defined threshold value to determine if a short-circuit fault exists. This solution is perfect when the aim is to protect a single device, but in the case of a medium-voltage NPC converter with several semiconductor devices in series/parallel, this solution has to be combined with another method to be able to detect and protect the drive in typically less than 10 $\mu$s, which may be a typical short-circuit withstanding time of such semiconductor devices (i.e., IGBTs and MOSFETs). This is where the invention of the presented patent has raised with the aim of proposing a practicable solution that could be implemented to protect not only a single semiconductor switch but the medium-voltage drive system.

## DESCRIPTION OF THE INVENTION

Therefore, it is an objective of the present invention to provide a method for detecting a short-circuit in a power converter, which may contribute to protect the whole power converter, which may enable to detect the short-circuit before the power converter is damaged, and/or which may be carried out in a cost-effective and/or easy way. Further, it is an objective of the present invention to provide a controller for a power converter, with the controller carrying out the method. Furthermore, it is an object of the present invention to provide a computer program for detecting a short-circuit in a power converter, with the computer program reflecting the steps of the method, and a computer-readable medium on which the computer program is stored.

These objectives are achieved by the subject-matter of the independent claims. Further exemplary embodiments are evident from the dependent claims and the following description.

In particular, an objective of the present invention is achieved by a method for detecting a short-circuit in a power converter. The power converter comprises a first DC terminal, a second DC terminal, an AC terminal, a first semiconductor switch electrically coupled to the first DC terminal and the AC terminal, a second semiconductor switch electrically coupled to the second DC terminal and the AC terminal, and an inductance. The method comprises: receiving a voltage signal which is representative for a switch voltage measured over the first semiconductor switch and the second semiconductor switch; determining an inductance voltage over the inductance depending on the measured switch voltage and a DC voltage between the first and second DC terminals; determining a current flowing through the semiconductor switches depending on the determined inductance voltage; and determining that the short-circuit is present depending on the determined current and a predetermined current threshold.

The DC voltage may be known or measured in advance. The DC voltage may be fixed or variable. The DC voltage is unequal zero while the method is carried out. When the DC voltage is zero, the power converter does not operate and may be shut down. Before starting the above method, one of the semiconductor switches may be turned on and the other one may be turned off. For example, a turn-on signal may be sent to one of the semiconductor switches, e.g. to the first semiconductor switch, for turning on the corresponding semiconductor switch and a turn-off signal may be sent to the other one of the semiconductor switches, e.g. to the second semiconductor switch, for turning off the corresponding semiconductor switch.

The power converter may comprise a DC link coupling the DC terminals to each other via a DC capacitor. One of the DC terminals may be a DC- terminal and the other one of the DC terminals may be a DC+ terminal. The semiconductor switches may be directly coupled to the AC terminal or via another converter stage of the power converter. The power converter may comprise a clamp circuit, e.g. a di/dt clamp circuit. The power converter may comprise one or more further semiconductor switches, DC links, clamp circuits, and/or a neutral point terminal, e.g. between two of the DC links. The power converter may be referred to as Power Electronic Converter (PEC). The power converter may be Neutral Point Clamped (NPC) converter, a half-bridge, a single phase of a two-level converter, a complete two-level converter, or a 3L-ANPC converter.

The first and/or second semiconductor switch each may be an Insulated-Gate Bipolar Transistor (IGBT). At least one of the semiconductor switches may be a high-power semiconductor switch and may be referred to as power semiconductor chip.

The inductance may be a parasitic inductance, e.g. comprising one or more electric lines of the power converter, and/or a dedicated inductance component, such as an inductor, e.g a di/dt limiting inductor, e.g. a coil. In the former case, the inductance component may be omitted. This may contribute to a cost-efficiency, simplicity, and high reliability of the power converter. In any case, an inductance value of the inductance may be known in advance, e.g. by arranging the inductance component having the known inductance value and/or by measuring the parasitic inductance. The inductance component may be connected to a DC link capacitor of the DC link.

The present disclosure provides an indirect method to detect the short-circuit by supervising the voltage that is applied on the inductance in the commutation path. This short-circuit detection method may be applicable to a broad range of PECs, not limited to a specific topology or semiconductor technology, scaling with voltage and current of the PEC, having low implementation effort basing on existing measurements and circuits present in a typical PEC and thus not compromising the overall reliability. Furthermore, in PECs using IGBTs, short-circuit detection may be possible before the device enters the desaturation region, reducing the peak power and thus thermal stress on the device. Further, early detection of short-circuits allows turn-off sequences to be initiated at lower fault current levels compared to traditional DESAT detection methods, resulting overall in faster and more reliable fault containment.

According to an embodiment, the voltage signal, which is representative for the switch voltage, is representative for a first switch voltage and a second switch voltage. This enables to determine the contribution of the first and second semiconductor switches to the switch voltage. For example, the voltage signal may be representative for a sum of the first and second switch voltages. The first and second switch voltages may be measured.

According to an embodiment, when determining the inductance voltage over the inductance depending on the measured switch voltage and the DC voltage, the switch voltages are added together, the corresponding sum is subtracted from the DC voltage, and the difference is determined as the inductance voltage. This contributes to determine the inductance voltage over the inductance in an easy way.

According to an embodiment, when determining the current flowing through the semiconductor switches depending on the determined inductance voltage, the difference is integrated over the time and the corresponding integral is determined as the current. For example, the voltage-time-area over the inductance may be integrated. The integration enables to calculate a short-circuit current. When integrating the difference over the time, the difference or the integral may be divided by the inductance value, if the inductance value is constant. Otherwise, in case of the inductance value not being constant, the difference may be divided by the inductance value and this quotient may be integrated, wherein the corresponding integral may be the short-circuit current.

According to an embodiment, when determining that the short-circuit is present depending on the determined current and the predetermined current threshold, the short-circuit is determined as being present when the determined current reaches or exceeds the predetermined current threshold. The predetermined current threshold may be predetermined by a manufacturer of the power converter. The predetermined current threshold may be that current until which the semiconductor switches are not damaged, at least for a short period of time.

According to an embodiment, a reference DC voltage signal is sent to an energy source coupled to the DC terminals, wherein the energy source provides the DC voltage to the DC terminals upon receiving the reference DC voltage signal. In this case, the reference DC voltage signal may be representative for the DC voltage and the DC voltage may be referred to as reference DC voltage or DC voltage reference. Alternatively or additionally, a second DC voltage signal is received before determining the inductance voltage, wherein the second DC voltage signal is representative for the DC voltage and wherein the second DC voltage signal is determined from a voltage measurement. In this case, the DC voltage may be measured directly, e.g. at the DC link, or the switch voltages may be measured and the DC voltage may be derived from the measured switch voltages. For example, a mean value of the inductance voltage can be assumed to be zero. Therefore, a mean value or low pass filtered value of the sum of the switch voltages may correspond to the DC-voltage. So, if it is not the case already, the power converter should be supplied with energy in form of the DC voltage before carrying out the above method.

According to an embodiment, the at least parasitic inductance is an inductance component of the power converter. For example, the inductance component may be an inductor, e.g. a di/dt limiting inductor, e.g. a coil. The inductance component may be arranged in the commutation path of the power converter, e.g. between one of the semiconductor switches, e.g. the first semiconductor switch, and the DC-terminal to which the corresponding semiconductor switch is coupled. For example, if the power converter comprises the clamp circuit, the inductance component may be a part of the clamp circuit.

An objective is achieved by another method for detecting the short-circuit in the power converter. The power converter may correspond to the above power converter. For example, the power converter again comprises the first DC terminal, the second DC terminal, the AC terminal, the first semiconductor switch electrically coupled to the first DC terminal and the AC terminal, the second semiconductor switch electrically coupled to the second DC terminal and the AC terminal, and the inductance. The method comprises: receiving a voltage signal which is representative for the switch voltage measured over the first semiconductor switch and the second semiconductor switch; determining whether the switch voltage does not exceed a given forward voltage of the semiconductor switches; when the switch voltage does not exceed the given forward voltage, determining a duration during which the switch voltage does not exceed the given forward voltage; and determining that the short-circuit is present when the determined duration reaches or exceeds a duration threshold. When it is determined that the switch voltage does exceed the given forward voltage of the semiconductor switches, it may be determined that no short-circuit is present. The given forward voltage may be a normal and/or specific forward voltage of the semiconductor switches.

Determining the duration and determining that the short-circuit is present when the determined duration reaches or exceeds a duration threshold is based on the insight of the inventors that when neither the first semiconductor switch nor the second semiconductor switch see any voltage it can be concluded that the DC voltage is applied over the inductance. In this case, the current through the semiconductor switches is proportional to the DC voltage and the duration during which the voltage is present, and inverse proportional to the inductance value of the inductance. In turn and keeping in mind that the DC voltage and the inductance value are known in advance or by measurement, the duration threshold may be easily determined depending on the predetermined current threshold, and it is sufficient to measure the duration only and to compare it with the duration threshold.

Therefore, in the words of the first aspect above, the method according to the second aspect comprises the step of determining the inductance voltage over the parasitic inductance depending on the measured switch voltage and the DC voltage by recognizing that the switch voltage does not exceed the given forward voltage of the semiconductor switches and by setting the inductance voltage as the DC voltage. Further, in this case, the duration is representative for the current, because the duration is proportional to the current and because the proportionality factor, i.e. the inductance value divided by the DC voltage, is known. So, both aspects are based on the same inventive idea, and the steps of the corresponding methods are the same or at least similar, wherein the method according to the second aspect may be even faster, simpler, more cost-efficient, and/or more reliable than the method according to the first aspect.

The above advantages and/or effects of the method according to the first aspect may be transferred to the method according to the second aspect. Therefore, a repetition of these advantages and/or effects is omitted and it is referred to the above explanations only in order to provide a concise description. Further, the physical features of the power converter according to the first aspect may be transferred to physical features of the power converter according to the second aspect. In other words, the above two methods may be carried out at the same power converter.

According to an embodiment, the duration threshold is determined by multiplying an inductance value of the inductance with a predetermined maximum fault current and by dividing the corresponding product by a DC voltage between the first and second DC terminals. The predetermined maximal fault current may correspond to the above current threshold.

According to an embodiment, the reference DC voltage signal is sent to the energy source coupled to the DC terminals, wherein the energy source provides the DC voltage to the DC terminals upon receiving the reference DC voltage signal. In this case, the reference DC voltage signal may be representative for the DC voltage and the DC voltage may be referred to as reference DC voltage or DC voltage reference. Alternatively or additionally, the second DC voltage signal is received before determining the duration threshold, wherein the second DC voltage signal is representative for the DC voltage and wherein the second DC voltage signal is determined from the voltage measurement. In this case, the DC voltage may be measured directly, e.g. at the DC link, or the switch voltages may be measured and the DC voltage may be derived from the measured switch voltages. For example, a mean value of the inductance voltage can be assumed to be zero. Therefore, a mean value or low pass filtered value of the sum of the switch voltages may correspond to the DC-voltage.

According to an embodiment, the inductance is the inductance component of the power converter.

An objective is achieved by a controller for controlling the power converter. The controller comprises: an input terminal for receiving one or more of the voltage signals; an output terminal for sending one or more control signals to the power converter; and a processor configured for carrying out at least one of the above methods.

An objective is achieved by a computer program for detecting the short-circuit in the power converter. The computer program, when being carried out by the processor of the controller for controlling the power converter, carrying out at least one of the above methods.

An objective is achieved by a computer-readable medium on which the computer program is stored.

The above features, advantages and/or effects of one or both of the above methods, in particular according to the first and/or second aspects, may be transferred to the controller, the computer program, and/or the computer-readable medium, or vice versa. Therefore, a repetition of these features, advantages, and/or effects is omitted and it is referred to the above explanations only in order to provide a concise description.

The above and other aspects of the invention will be apparent from and elucidated with reference to the embodiments described hereinafter.

BRIEF DESCRIPTION OF THE DRAWINGS

The subject matter of the invention will be explained in more detail in the following text with reference to exemplary embodiments which are illustrated in the attached drawings.

Fig. 1 schematically shows a circuit diagram of an exemplary embodiment of a power converter;

Fig. 2 schematically shows a flow-chart of an exemplary embodiment of a method for detecting a short-circuit in a power converter;

Fig. 3 schematically shows a flow-chart of another exemplary embodiment of a method for detecting a short-circuit in a power converter.

The reference symbols used in the drawings, and their meanings, are listed in summary form in the list of reference symbols. In principle, identical parts are provided with the same reference symbols in the figures.

DETAILED DESCRIPTION OF EXEMPLARY EMBODIMENTS

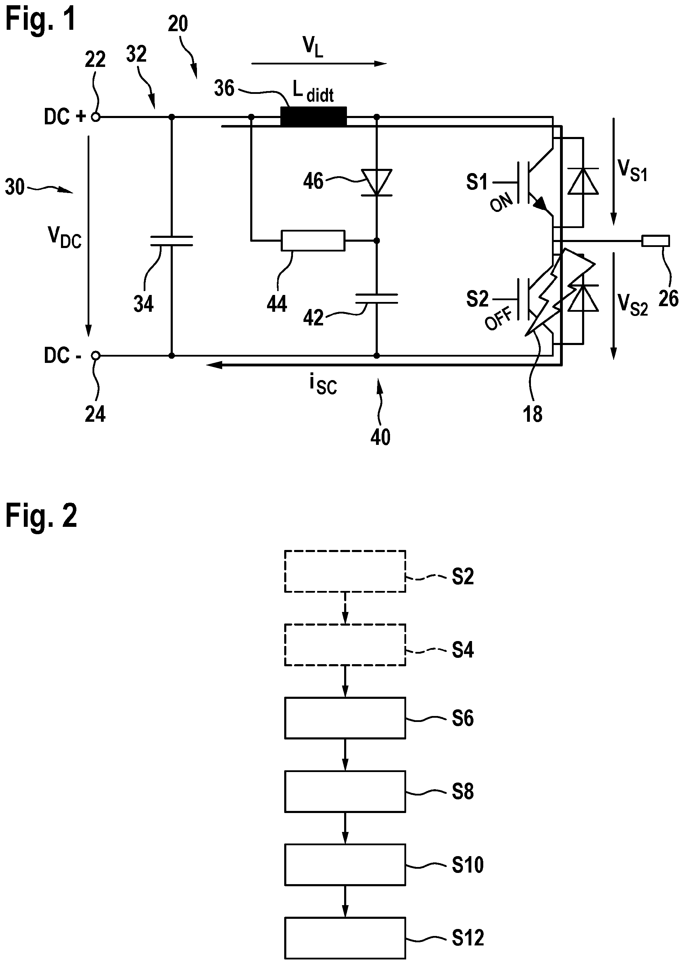

Fig. 1 schematically shows a circuit diagram of an exemplary embodiment of a power converter 20. The power converter 20 may be a Power Electronic Converter (PEC). The power converter 20 may be a part of a Neutral Point Clamped (NPC) converter, a half-bridge, a single phase of a two-level converter, a part of a complete two-level converter, or a part of a 3L-ANPC converter. The power converter 20 may be used in an inverter or rectifier. The power converter 20 may be implemented as or for a medium-voltage drive application.

The power converter 20 comprises a first DC terminal 22, e.g. a DC+ terminal, a second DC terminal 24, e.g. a DC- terminal, an output, e.g. provided by an AC terminal 26, a first semiconductor switch S1 electrically coupled to the first DC terminal 22 and the AC terminal 26, a second semiconductor switch S2 electrically coupled to the second DC terminal 24 and the AC terminal 26, and an inductance. The DC terminals 22, 24 are coupled to an energy source 30, in particular a DC energy source, e.g. a battery, a rectifier, e.g. an active rectifier, a solar panel, a DC grid, etc. The semiconductor switches S1, S2 may be directly coupled to the AC terminal 26 or via another converter stage (not shown) of the power converter 20, e.g. in case of a three-level NPC or ANPC converter. The first and/or second semiconductor switches S1, S2 each may be an Insulated-Gate Bipolar Transistor (IGBT). At least one of the semiconductor switches S1, S2 may be a high-power semiconductor switch and may be referred to as power semiconductor switch.

The power converter 20 may further comprise a DC link 32 coupling the DC terminals 22, 24 to each other, e.g. via a first capacitor 34, in other words a DC capacitor. The power converter 20 may further comprise a clamp circuit 40, e.g. a di/dt clamp circuit. The clamp circuit 40 may comprise a second capacitor 42 and a diode 46 electrically arranged in series and electrically coupling the DC terminals 22, 24 to each other. The clamp circuit 40 may further comprise a resistor 44 coupling a node between the second capacitor 42 and the diode 46 to the first DC terminal 22.

The inductance may be a parasitic inductance, e.g. comprising one or more electric lines of the power converter, and/or an inductance component 36, such as an inductor, e.g. a di/dt limiting inductor, e.g. a coil. In the former case, the inductance component 36 may be omitted. The inductance component 36 may be connected to the first capacitor 34 of the DC link 32. The inductance component 36 may be arranged between to nodes at which the clamp circuit 40 is electrically coupled to the first DC terminal 22. The one or more electric lines forming the parasitic inductance may be a part of a commutation path of the power converter 20. The commutation path may extend from one of the DC terminals 22, 24 via the semiconductor switches S1, S2 to the other one of the DC terminals 22, 24. In any case, an inductance value of the inductance may be known in advance, e.g. by arranging the inductance component 36 having the known inductance value and/or by measuring the parasitic inductance in at least a part of the commutation path.

The power converter 20 may comprise one or more further semiconductor switches, DC links, clamp circuits, and/or a neutral point terminals, e.g. between two of the corresponding further DC links.

In case of a fault of the power converter 20, a short-circuit 18 may be present in the power converter 20. For example, the short-circuit 18 may bypass one of the semiconductor switches S1, S2, e.g. the second semiconductor switch S2. In this case, the output of the power converter 20, which is the AC terminal 26 in this embodiment, may be directly coupled with the second DC terminal 24. If the first semiconductor S1 is turned on and as such electrically conductive, the first and second DC terminals 22, 24 are short-circuited by the turned-on first semiconductor switch S1 and the short-circuit 18.

In the following, two different methods which are based on the same inventive idea and possible implementations thereof are described at the example of the power converter 20. However, the proposed methods are generic in nature and can be applied to multi-level topologies like for example the 3L-ANPC. The topology of the 3L-ANPC may be easily derived from the power converter shown in figure 1. In particular, for the 3L-ANPC the power converter 20 may be duplicated wherein the double may be arranged below the power converter 20, e.g. such that the commutation path from the second semiconductor switch S2 to the second DC terminal 24 is shared between the power converter 20 and the double, wherein this shared part of the commutation path forms the neutral point potential of the 3L-ANPC. Further, the outputs of the power converter 20 and the double may be coupled to each other via two further semiconductor switches, wherein a node between the two further semiconductor chips may provide an AC terminal and as such an output of the 3L-ANPC.

Below methods and descriptions will be based on the exemplary fault case shown in Figure 1, i.e. the two-level power converter 20 with faulted second semiconductor switch S2 (fail to short) and with the first semiconductor switch S1 being turned on into the short-circuit 18. However, the proposed methods are applicable to different fault cases including but not limited to a short of an upper or lower half-bridge switch, short circuit types I, II and III, insulation failure, and output short to one of the DC-terminals 22, 24.

Fig. 2 schematically shows a flow-chart of an exemplary embodiment of a method for detecting a short-circuit in a power converter, e.g. the short-circuit 18 in the above power converter 20. The method may be carried out when energy is supplied to the power converter 20 by the energy source 30. So, the method may be carried out when a DC voltage $V_{DC}$ between the DC terminals 22, 24 is unequal zero. The method may be carried out by a controller configured for controlling the power converter 20. The controller may be a part of the power converter 20 or may be external with respect to the power converter 20.

In an optional step S2, which may be carried out when the energy is not yet supplied to the power converter 20 or when the amount of the DC voltage $V_{DC}$ is not yet known, a reference DC voltage signal may be sent to the energy source 30 coupled to the DC terminals 22, 24. The reference DC voltage signal may be representative for the DC voltage $V_{DC}$ and the DC voltage $V_{DC}$ may be referred to as reference DC voltage or DC voltage reference. The energy source 30 may provide the DC voltage $V_{DC}$ to the DC terminals 22, 24 upon receiving the reference DC voltage signal. Alternatively or additionally, a second DC voltage signal may be received before determining an inductance voltage $V_L$ over the above explained inductance, i.e. the inductance component 36 and/or the parasitic inductance, wherein the second DC voltage signal may be representative for the DC voltage $V_{DC}$ and wherein the DC voltage may be derived from the measured switch voltages. The second voltage signal may be generated by a voltmeter and may be received by the controller (not shown) for controlling the power converter 20.

In an optional step S4, a turn-on signal ON may be sent to the first semiconductor switch S 1 for turning on the first semiconductor switch S 1 and a turn-off signal OFF may be sent to the second semiconductor switch S2 for turning off the second semiconductor switch S2. In this situation, the short-circuit 18 short-circuits the DC terminals 22, 24 with each other.

In a step S6, a voltage signal which is representative for a switch voltage $v_{S1}$, $v_{S2}$ measured over the first semiconductor switch S 1 and the second semiconductor switch S2 may be measured. For example, the voltage signal, which is representative for the switch voltage $v_{S1}$, $v_{S2}$, may be representative for a first switch voltage vsi over the first semiconductor switch S 1 and a second switch voltage $v_{S2}$ over the second semiconductor switch S2.

In a step S8, the inductance voltage $V_L$ over the inductance may be determined depending on the measured switch voltage(s) $v_{S1}$, $v_{S2}$ and the DC voltage $V_{DC}$ between the first and second DC terminals 22, 24. For example, the switch voltages $v_{S1}$, $v_{S2}$ may be added together, the corresponding sum may be subtracted from the DC voltage $V_L$, and the difference may be determined as the inductance voltage $V_L$, e.g. in accordance with the following formulas:

$$V_{dc} = V_L + V_{S1} + V_{S2} \iff V_L = V_{dc} - V_{S1} - V_{S2}$$

In a step S10, a current isc, in particular a short-circuit current, flowing through the semiconductor switches S1, S2 may be determined depending on the determined inductance voltage $V_L$. For example, the difference determined in step S8 may be integrated over the time and the corresponding integral may be determined as the current isc, e.g. in accordance with the following formula:

$$i_{SC} = \int \frac{V_L(t)}{L_{didt}} \, dt = \int \frac{V_{dc} - V_{S1}(t) - V_{S2}(t)}{L_{didt}} \, dt$$

In a step S12, it may be determined that the short-circuit 18 is present depending on a predetermined current threshold $i_{SC\_max}$ being the maximal acceptable fault current, as shown below. For example, the short-circuit 18 may be determined as being present when the current isc determined in step S10 reaches or exceeds the predetermined current threshold $i_{SC\_max}$. Then, a predetermined fault reaction, e.g. a predetermined turn-off sequence, may be executed.

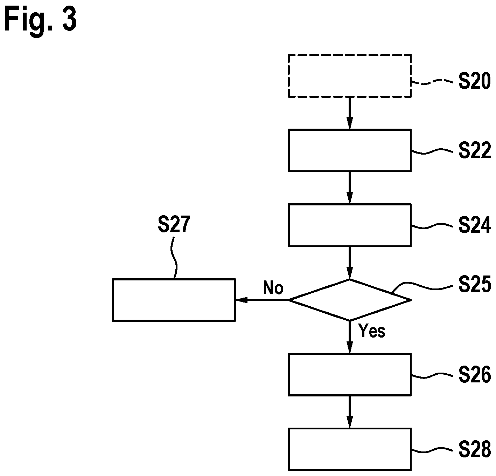

Fig. 3 schematically shows a flow-chart of another exemplary embodiment of a method for detecting a short-circuit in a power converter, e.g. the short-circuit 18 of the above power converter 20. The method may be carried out when energy is supplied to the power converter 20 by the energy source 30. So, the method may be carried out when the DC voltage $V_{DC}$ between the DC terminals 22, 24 is unequal zero. The method may be carried out by a controller configured for controlling the power converter 20. The controller may be a part of the power converter 20 or may be external with respect to the power converter 20.

An optional step S20 may correspond to the optional step S2 explained above.

An optional step S22 may correspond to the optional step S4 explained above.

In a step S24, a voltage signal which is representative for the switch voltages $v_{S1}$, $v_{S2}$ over the first semiconductor switch S1 and the second semiconductor switch S2 may be received.

In a step S25, it may be determined, whether the switch voltages $v_{S1}$, $v_{S2}$ do not exceed a given forward voltage of the semiconductor switches S1, S2. If the condition of step S25 is fulfilled, the method proceeds in a step S26. If the condition of step S25 is not fulfilled, the method proceeds in a step S27.

The measurement of any voltage exceeding the normal forward voltage over the semiconductor switches S1, S2 may be referred to as "voltage feedback". This voltage feedback measurement is traditionally present in power converters using IGBTs to be able to detect desaturation of the semiconductors. If neither the first semiconductor switch S1 nor the second semiconductor switch S2 see any voltage feedback, it may be concluded that the DC voltage $V_{DC}$ is applied over the inductance, as may be seen from the formulas firstly presented above. Further, assuming that the DC voltage $V_{DC}$ is constant during a first point ti in time and a second point $t_2$ in time, the formula secondly presented above, may be simplified as:

$$i_{SC} = \int \frac{V_L(t)}{L_{didt}}\, dt \approx \int_{t_1}^{t_2} \frac{V_{dc}}{L_{didt}}\, dt = \frac{V_{dc}}{L_{didt}}(t_2 - t_1) = \frac{V_{dc}}{L_{didt}} t_{SC}$$

with tsc being the duration between the time points ti and $t_2$.

In step S26, a duration during which the switch voltage $v_{S1}$, $v_{S2}$ do not exceed the given forward voltage may be determined.

In step S27, the method may be terminated and/or it may be determined that no short-circuit is present.

In a step S28, it may be determined that the short-circuit 18 is present when the determined duration reaches or exceeds a duration threshold. The duration threshold may be determined by multiplying an inductance value $L_{didt}$ of the inductance with a predetermined maximum fault current and by dividing the corresponding product by the DC voltage $V_{DC}$ between the first and second DC terminals 22, 24, e.g. by the following formula:

$$t_{SC\_max} = \frac{L_{didt}}{V_{dc}} i_{SC\_max}$$

with $i_{SC\_max}$ being the maximal acceptable fault current and thereby the predetermined current threshold. Then, the predetermined fault reaction, e.g. a predetermined turn-off sequence, may be executed.

While the invention has been illustrated and described in detail in the drawings and foregoing description, such illustration and description are to be considered illustrative or exemplary and not restrictive; the invention is not limited to the disclosed embodiments. Other variations to the disclosed embodiments can be understood and effected by those skilled in the art and practising the claimed invention, from a study of the drawings, the disclosure, and the appended claims.

In the claims, the word "comprising" does not exclude other elements or steps, and the indefinite article "a" or "an" does not exclude a plurality. A single processor or controller or other unit may fulfil the functions of several items recited in the claims. The mere fact that certain measures are recited in mutually different dependent claims does not indicate that a combination of these measures cannot be used to advantage. Any reference signs in the claims should not be construed as limiting the scope.

LIST OF REFERENCE SYMBOLS

| | |
|---|---|
| 18 | short-circuit |
| 20 | power converter |
| 22 | first DC terminal |
| 24 | second DC terminal |
| 30 | energy source |
| 32 | DC link |
| 34 | first capacitor |
| 36 | inductance component |
| 40 | clamp circuit |
| 42 | second capacitor |
| 44 | resistor |
| 46 | diode |
| S1 | first semiconductor switch |
| S2 | second semiconductor switch |
| ON | turn-on signal |
| OFF | turn-off signal |
| vi | first switch voltage |
| $v_2$ | second switch voltage |
| $V_L$ | inductance voltage |
| $V_{DC}$ | DC voltage |
| $i_{SC}$ | current |
| $L_{didt}$ | inductance value |

**Claims**

1. A method for detecting a short-circuit (18) in a power converter (20), the power converter (20) comprising a first DC terminal (22), a second DC terminal (24), an AC terminal (26), a first semiconductor switch (S1) electrically coupled to the first DC terminal (22) and the AC terminal (26), a second semiconductor switch (S2) electrically coupled to the second DC terminal (24) and the AC terminal (26), and an inductance, the method comprising:

   receiving a voltage signal which is representative for a switch voltage ($v_{S1}$, $v_{S2}$) measured over the first semiconductor switch (S1) and the second semiconductor switch (S2);
   determining an inductance voltage ($V_L$) over the inductance depending on the measured switch voltage ($v_{S1}$, $v_{S2}$) and a DC voltage ($V_{DC}$) between the first and second DC terminals (22, 24);
   determining a current (isc) flowing through the semiconductor switches (S1, S2) depending on the determined inductance voltage ($V_L$); and
   determining that the short-circuit (18) is present depending on the determined current (isc) and a predetermined current threshold.

2. The method in accordance with claim 1, wherein
   the voltage signal, which is representative for the switch voltage ($v_{S1}$, $v_{S2}$), is representative for a first switch voltage ($v_{S1}$) and a second switch voltage ($v_{S2}$).

3. The method in accordance with claim 2, wherein
   , when determining the inductance voltage ($V_L$) over the inductance depending on the measured switch voltage ($v_{S1}$, $v_{S2}$) and the DC voltage ($V_{DC}$), the switch voltages ($v_{S1}$, $v_{S2}$) are added together, the corresponding sum is subtracted from the DC voltage ($V_{DC}$), and the difference is determined as the inductance voltage ($V_L$).

4. The method in accordance with claim 3, wherein
   , when determining the current (isc) flowing through the semiconductor switches (S1, S2) depending on the determined inductance voltage ($V_L$), the difference is integrated over the time and the corresponding integral is determined as the current (isc).

5. The method in accordance with claim 4, wherein
   , when determining that the short-circuit (18) is present depending on the determined current (isc) and the predetermined current threshold, the short-circuit (18) is determined as being present when the determined current (isc) reaches or exceeds the predetermined current threshold.

6. The method in accordance with one of the preceding claims, wherein

   a reference DC voltage signal is sent to an energy source coupled to the DC terminals (22, 24), wherein the energy source provides the DC voltage ($V_{DC}$) to the DC terminals (22, 24) upon receiving the reference DC voltage signal; and/or
   a second DC voltage signal is received before determining the inductance voltage ($V_L$), wherein the second DC voltage signal is representative for the DC voltage ($V_{DC}$) and wherein the second DC voltage signal is determined from a voltage measurement.

7. The method in accordance with one of the preceding claims, wherein
   the at least parasitic inductance is an inductance component (36) of the power converter (20).

8. A method for detecting a short-circuit (18) in a power converter (20), the power converter (20) comprising a first DC terminal (22), a second DC terminal (24), an AC terminal (26), a first semiconductor switch (S1) electrically coupled to the first DC terminal (22) and the AC terminal (26), a second semiconductor switch (S2) electrically coupled to the second DC terminal (24) and the AC terminal (26), and an inductance, the method comprising:

   receiving a voltage signal which is representative for a switch voltage ($v_{S1}$, $v_{S2}$) measured over the first semiconductor switch (S1) and the second semiconductor switch (S2);
   determining whether the switch voltage ($v_{S1}$, $v_{S2}$) does not exceed a given forward voltage of the semiconductor switches (S1, S2),
   , when the switch voltage ($v_{S1}$, $v_{S2}$) does not exceed the given forward voltage, determining a duration during which the switch voltage ($v_{S1}$, $v_{S2}$) does not exceed the given forward voltage; and

determining that the short-circuit (18) is present when the determined duration reaches or exceeds a duration threshold.

9. The method in accordance with claim 8, wherein
   the duration threshold is determined by multiplying an inductance value ($L_{didt}$) of the inductance with a predetermined maximum fault current and by dividing the corresponding product by a DC voltage ($V_{DC}$) between the first and second DC terminals (22, 24).

10. The method in accordance with claim 9, wherein

    a reference DC voltage signal is sent to an energy source coupled to the DC terminals (22, 24), wherein the energy source provides the DC voltage ($V_{DC}$) to the DC terminals (22, 24) upon receiving the reference DC voltage signal; and/or
    a second DC voltage signal is received before determining the duration threshold, wherein the second DC voltage signal is representative for the DC voltage ($V_{DC}$) and wherein the second DC voltage signal is determined from a voltage measurement.

11. The method in accordance with one of claims 8 to 10, wherein
    the inductance is an inductance component (36) of the power converter (20).

12. A controller for controlling a power converter (20), the controller comprising.

    an input terminal for receiving one or more voltage signals;
    an output terminal for sending one or more control signals to the power converter (20); and
    a processor configured for carrying out the method in accordance with one of the preceding claims.

13. A computer program for detecting a short-circuit in a power converter (20), the computer program, when being carried out by a processor of a controller for controlling the power converter (20), carrying out the method in accordance with any one of claims 1 to 11.

14. A computer-readable medium on which a computer program in accordance with claim 13 is stored.

# Fig. 1

# Fig. 2

Fig. 3

Europäisches
Patentamt

European
Patent Office

Office européen
des brevets

# EUROPEAN SEARCH REPORT

**Application Number**

EP 23 17 7505

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X | US 2012/206841 A1 (HARBOURT CYRUS DAVID [US] ET AL) 16 August 2012 (2012-08-16) | 1-6, 12-14 | INV. H02M1/32 H02M7/5387 G01R31/42 G01R31/52 |
| Y | * the whole document * | 7 | |
| X | US 6 304 472 B1 (NAGASU MASAHIRO [JP] ET AL) 16 October 2001 (2001-10-16) | 1,12-14 | |
| Y | * column 8, line 1 - column 9, line 21; figures 8A, 8B * | 7 | |
| X | US 2009/251831 A1 (SHIBA KENJIRO [JP] ET AL) 8 October 2009 (2009-10-08) * paragraph [0184]; figures 14, 21 * | 8-14 | |
| X | WO 2020/120312 A1 (BOSCH GMBH ROBERT [DE]) 18 June 2020 (2020-06-18) * the whole document * | 1,12-14 | |
| A | US 8 872 455 B2 (TREMEL CHRIS J [US]; VILAR ERIC [US]; DEERE & CO [US]) 28 October 2014 (2014-10-28) * column 11, lines 1-30; figures 1-3 * | 1-14 | **TECHNICAL FIELDS SEARCHED (IPC)** |
| A | EP 2 747 260 B1 (GE ENERGY POWER CONV GMBH [DE]) 14 August 2019 (2019-08-14) * the whole document * | 1-14 | H02M |

The present search report has been drawn up for all claims

| Place of search | Date of completion of the search | Examiner |
|---|---|---|
| The Hague | 2 November 2023 | van Wesenbeeck, R |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

    ...................................................................
& : member of the same patent family, corresponding document

EPO FORM 1503 03.82 (P04C01)

## ANNEX TO THE EUROPEAN SEARCH REPORT
## ON EUROPEAN PATENT APPLICATION NO.

EP 23 17 7505

This annex lists the patent family members relating to the patent documents cited in the above-mentioned European search report.
The members are as contained in the European Patent Office EDP file on
The European Patent Office is in no way liable for these particulars which are merely given for the purpose of information.

02-11-2023

| Patent document cited in search report | | | Publication date | Patent family member(s) | | | Publication date |
|---|---|---|---|---|---|---|---|
| US 2012206841 | A1 | | 16-08-2012 | CN | 102710108 | A | 03-10-2012 |
| | | | | EP | 2487781 | A2 | 15-08-2012 |
| | | | | JP | 2012170318 | A | 06-09-2012 |
| | | | | US | 2012206841 | A1 | 16-08-2012 |
| US 6304472 | B1 | | 16-10-2001 | CN | 1274192 | A | 22-11-2000 |
| | | | | JP | 3454186 | B2 | 06-10-2003 |
| | | | | JP | 2000324846 | A | 24-11-2000 |
| | | | | KR | 20010014862 | A | 26-02-2001 |
| | | | | US | 6304472 | B1 | 16-10-2001 |
| US 2009251831 | A1 | | 08-10-2009 | CN | 101485080 | A | 15-07-2009 |
| | | | | DE | 112007001594 | T5 | 07-05-2009 |
| | | | | JP | 4747968 | B2 | 17-08-2011 |
| | | | | JP | 2008011683 | A | 17-01-2008 |
| | | | | US | 2009251831 | A1 | 08-10-2009 |
| | | | | WO | 2008001949 | A1 | 03-01-2008 |
| WO 2020120312 | A1 | | 18-06-2020 | DE | 102018221593 | A1 | 18-06-2020 |
| | | | | WO | 2020120312 | A1 | 18-06-2020 |
| US 8872455 | B2 | | 28-10-2014 | AU | 2013266894 | A1 | 10-07-2014 |
| | | | | CN | 104321656 | A | 28-01-2015 |
| | | | | EP | 2852847 | A1 | 01-04-2015 |
| | | | | JP | 2015519035 | A | 06-07-2015 |
| | | | | US | 2013314014 | A1 | 28-11-2013 |
| | | | | WO | 2013176708 | A1 | 28-11-2013 |
| EP 2747260 | B1 | | 14-08-2019 | CA | 2836432 | A1 | 21-06-2014 |
| | | | | CN | 103888002 | A | 25-06-2014 |
| | | | | DE | 102012224336 | A1 | 26-06-2014 |
| | | | | EP | 2747260 | A2 | 25-06-2014 |
| | | | | US | 2014177306 | A1 | 26-06-2014 |